# EUROPÄISCHE PATENTANMELDUNG

(11) **EP 1 289 132 A2**
(43) Veröffentlichungstag der Anmeldung: **05.03.2003**
(21) Anmeldenummer: 02018588.0
(22) Anmeldetag: 19.08.2002
(51) Int. Cl.: H03H 3/08

(54) **Verfahren zur Herstellung von Oberflächenwellen-Bauelementen**

(30) Priorität: 27.08.2001 DE 10141855
(71) Anmelder: Paul-Drude-Institut für Festkörperelektronik, 10117 Berlin (DE)
(72) Erfinder: Chilla, Eduard, Dr., 15711 Zeesen (DE); Koch, Reinhold, Dr., 14050 Berlin (DE); Perepellitschenko, Ludmilla, 16540 Hohen Neuendorf (DE); Seidel, Werner, 12683 Berlin (DE)
(74) Vertreter: Heusler, Wolfgang, Dipl.-Ing.

(57) **Zusammenfassung**

Es wird ein Verfahren zur Herstellung eines OFW-Bauelements (10) mit einem Substrat (1) beschrieben, auf dem eine Vielzahl von strukturierten leitfähigen Schichten (2, 8) lateral nebeneinander angeordnet werden, wobei eine erste Abscheidungsphase, bei der mit vorbestimmten lateralen Abständen (4) erste leitfähige Schichten (2) erzeugt werden, eine allseitige Belegung der ersten leitfähigen Schichten (2) mit Trennschichten (3) aus einer organischen Substanz, wobei die Oberfläche (5) des Substrats (1) in den Abständen (4) frei bleibt, und eine zweite Abscheidungsphase vorgesehen sind, bei der auf dem Substrat (1) zwischen den ersten leitfähigen Schichten (2) zweite leitfähige Schichten (8) erzeugt werden, die von den ersten leitfähigen Schichten (2) durch die Trennschichten (3) getrennt sind.

## Beschreibung

Die Erfindung betrifft ein Verfahren zur Herstellung von Oberflächenwellen-Bauelementen und insbesondere ein Verfahren zur Herstellung von lateral strukturierten Elektrodenschichten auf piezoelektrischen Substraten. Die Erfindung betrifft auch ein mit einem derartigen Verfahren hergestelltes Oberflächenwellen-Bauelement und Anwendungen von Oberflächenwellen-Bauelementen.

Oberflächenwellen (OFW, SAW) sind Moden elastischer Energie, die sich an der Oberfläche eines Festkörpers mit Schallgeschwindigkeit ausbreiten können. Technologische Anwendungen von akustischen OFW bestehen beispielsweise in der Hochfrequenzsignalverarbeitung. Mit planar gebildeten, metallischen Schallwandlern oder Elektrodenschichten (Metallfinger oder Metallstreifen) werden auf der Oberfläche eines piezoelektrischen Substrates akustische Wellen angeregt, die durch die Gitterdeformation von starken elektrischen Feldern begleitet sind. Es wird insbesondere eine effiziente Konversion hochfrequenter elektrischer Signale in OFW's und umgekehrt ermöglicht.

Es besteht ein starkes Interesse an OFW-Bauelementen, die bei hohen Frequenzen bis in den GHz-Bereich arbeiten. Eine sprunghafte Entwicklung hat sich in den letzten Jahren durch die Fortschritte in der Mobilkommunikationstechnik ergeben, wobei insbesondere auf die Standards GSM (Global System for Mobile Communications), D-AMPS (Digital American Mobile Phone System), IS-95 (Interim Standard of the Telecommunication Industry Association) und PDC (Personal Digital Communications) hinzuweisen ist. Darüber hinaus gibt es eine Vielzahl weiterer Systeme und Frequenzbänder, die weltweit zur Telekommunikation verwendet werden.

Bauelemente mit Arbeitsfrequenzen von ca. 2 GHz werden in der sogenannten dritten Generation der Mobilkommunikation für die Standards UMTS (Universal Mobile Telecommunication System) und ca. 5 GHz für WLAN (Wireless Local Area Network) benötigt (siehe S. Lehtonen et al. in "IEEE Ultrasonics Symposium", 1999, Seite 394-399). Derart hohe Frequenzen stellen für die OFW-Technik eine große Herausforderung dar. Bei einer Ausbreitungsgeschwindigkeit der Oberflächenwellen von 3000 m/s (z. B. v_{quarz} = 3158 m/s) würde sich bei einer Frequenz von beispielsweise 3 GHz eine Wellenlänge von 1 µm ergeben. Werden einfache Interdigitalwandler (IDT) mit zwei Metallfingern pro Wellenlänge zur OFW-Erzeugung verwendet, wobei entsprechend herkömmlich aufgebauten OFW-Bauelementen mit einem Metallisierungsverhältnis von beispielsweise η = 0.5 der Schallwandlerabstand (Fingerabstand) gleich der Schallwandlerbreite (Fingerbreite) ist, so wären Strukturbreiten von 0.25 µm erforderlich.

Diese einfachen Strukturen besitzen jedoch mehrere Nachteile. IDT mit zwei Metallfingern pro Wellenlänge besitzen eine bidirektionale Energieabstrahlung, so dass nur maximal 25% der erzeugten Leistung den Filterausgang erreicht. Des Weiteren führen zeitverzögerte Echosignale (sog. "triple-transit") zu einer Welligkeit im Passband, was mit einer Variation der Gruppenlaufzeit verbunden ist. Die Wandler werden daher häufig elektrisch stark fehlangepasst betrieben, so dass sich eine große Übertragungsdämpfung von rund 15 - 20 dB ergibt. Zur Unterdrückung oder gezielten Nutzung interner Reflektionen werden sog. Splitfinger-IDT (vier Metallfinger pro Wellenlänge) benötigt, die gegenüber den Normalfinger-IDT nochmals eine Halbierung der Strukturbreite erfordern.

Es sind auch OFW-Bauelemente bekannt, die Unidirektionalwandler (UDT) bilden, bei denen Wellen vorrangig in eine Richtung abgestrahlt werden. UDT besitzen prinzipiell eine um bis zu 6 dB geringere Übertragungsdämpfung im Vergleich zu bidirektionalen Wandlern. Außerdem ermöglichen sie eine stärkere Unterdrückung von Echosignalen durch Einstellung interner elektrischer und mechanischer Streuung. UDT werden beispielsweise von J. M. Hode et al. (in "IEEE Ultrasonics Symposium", 1995, Seite 39-50), C. S. Hartmann und B. P. Abbott in "IEEE Ultrasonics Symposium", 1989, Seite 79-89), T. Kodama et al. (in "IEEE Ultrasonics Symposium", 1986, Seite 59-64), T. Thorvaldsson (in "IEEE Ultrasonics Symposium" 1989, Seite 91-96) und D. P. Morgan (in "IEEE Ultrasonics Symposium", 1999, Seite 107-111) beschrieben. Bei diesen herkömmlichen OFW-Bauelementen, die in der Regel mehr Finger pro Wellenlänge als einfache Bidirektionalwandler und variierende Fingerbreiten und Fingerabstände besitzen, werden Arbeitsfrequenzen in MHz- bis GHz-Bereich, relative Bandbreiten < 10%, eine Einfügedämpfung < 10 dB, eine Welligkeit ± 0.5 dB und eine Gruppengeschwindigkeitsänderung von 50-500 ns erreicht.

Es sind auch OFW-Bauelemente bekannt, die auf der Basis von stationären (stehenden) Wellen arbeiten, wie z. B. ein Hochfrequenzfilter des Herstellers Fujitsu mit einer Arbeitsfrequenz von 2.45 GHz. Mit sog. Ein- oder Mehrtorresonatoren werden angeregte Wellen unter Verwendung von Wellenleitern und Reflektoren lokalisiert. Die Streuung von Wellen erfolgt an Metallstreifen oder Gruben. Es wurden elektrisch und mechanisch gekoppelte Resonatoren entwickelt. Diese OFW-Bauelemente besitzen zwar Vorteile in Bezug auf sehr geringe Verluste (< 3 dB), eine große Flankensteilheit und eine gute Unterdrückung der Seitenbänder. Die Betriebsparameter sind jedoch empfindlich von einer genauen und reproduzierbaren Strukturierung der Bauelementkomponenten abhängig. Außerdem wird ein hoher Metallisierungsgrad der Substratoberfläche und eine sehr genaue Einstellung der Dicken von planar gebildeten Bauelementkomponenten erwünscht. Dies ist mit den herkömmlichen Technologien zur Herstellung von OFW-Bauelementen nur beschränkt möglich.

OFW-Resonatoren benötigen in der Regel zwei Finger pro Wellenlänge. Für schwach koppelnde Substrate, d. h. Materialien mit kleinem Kopplungsfaktor wie z. B. Quarz, ist die mechanische Streuung dominierend. Für stark koppelnde Materialien, wie z. B. Lithiumniobat oder Lithiumtantalat, überwiegt die elektrische Streuung (oder Reflektion). Die mechanische Streuung erfolgt an den Elektrodenkanten, während das elektrische Streuzentrum in der Elektrodenmitte liegt. Die mechanischen und elektrischen Reflektionen verhalten sich bei Änderung des Metallisierungsgrades und der Elektrodendicke unterschiedlich. Die maximale Frequenz eines OFW-Bauelementes wird bei einer prozessbedingten kleinsten Strukturbreite erreicht, wenn Elektroden und Zwischenräume gleich groß sind, d. h. der Metallisierungsgrad ist η = 0.5.

Es sind Bemühungen bekannt, IDT's mit geringem Elektrodenabstand (NG-IDT = Narrow Gap Interdigital Transducer) herzustellen, bei denen hohe Frequenzen durch Anregung höherer Harmonischer (Oberwellen) erzeugt werden. Dies wird beispielsweise von H. Engan (in "IEEE Trans. Electron Dev." Band ED-16, 1969, Seite 1014 ff) und N. Sakairi et al. (in "IEEE Ultrasonics Symposium", 1992, Seite 143-146) beschrieben. Durch den Oberwellenbetrieb können zwar höhere Frequenzen erreicht werden. Die effektive Anregung höherer Harmonischer erfordert jedoch die Bereitstellung sehr geringer Spaltbreiten zwischen den Elektroden und ein hohes Metallisierungsverhältnis.

Von K. Yamanouchi et al. (in "Electron. Lett.", Bd. 21, S. 966-968, 1985) wird ein Strukturierungsverfahren beschrieben, bei dem unter Verwendung einer anodischen Oxidation ein hohes Metallisierungsverhältnis auf der Substratoberfläche erzielt wird. Bei diesem Verfahren werden jedoch zwischen den Metallelektroden des IDI keine echten Lücken gebildet. In den Abständen befindet sich oxidiertes Material, das zwar eine elektrische Isolation liefert, aber auch mit mehreren Nachteilen verbunden ist. So liefern die mit oxidiertem Material gefüllten Abstände nur eine beschränkte Isolation zwischen den metallischen Strukturen, was zu leitfähigen Brücken führen kann, die bei einem OFW-Bauelement einen Funktionsausfall zur Folge haben. Ein weiterer Nachteil des von K. Yamanouchi et al. beschriebenen Verfahrens besteht generell in der schwierigen Handhabbarkeit der anodischen Oxidation bei der Mikrostrukturierung von Oberflächen.

In WO 99/63663 wird die Herstellung von NG-IDT mit Elektrodenabständen im Bereich von einigen 10 nm beschrieben. Zur Herstellung von UDT-Gestaltungen werden in die Substratoberfläche Gruben geätzt, so dass eine Höhendifferenz zwischen geätzten und nicht geätzten Bereichen entsteht. Bei einer anschließenden Metallisierung werden die Gruben nur partiell aufgefüllt, so dass ein schmaler Abstand zwischen den einzelnen metallisierten Bereich verbleibt, der im Wesentlichen durch die Höhendifferenz zwischen der Metalloberfläche in den Gruben und dem Boden der Metallisierung auf den ungeätzten Flächen bestimmt ist. Die so hergestellten OFW-Bauelemente besitzen den Nachteil, dass sie notwendig eine unebene, nicht glatte Oberfläche besitzen. Durch die Stufenbildung werden unerwünschte mechanische Streuungen an den Kanten der Gruben erzeugt.

Von S. D. Evans et al. wird in "J. Am. Chem. Soc.", Band 113, 1991, Seite 5866-5868 die Erzeugung von selbstorganisierenden Schichten aus Mercaptansäuremolekülen beschrieben. Die selbstorganisierenden Schichten werden bisher insbesondere in der chemischen Technologie und Biotechnologie verwendet.

Die Aufgabe der Erfindung ist es, ein verbessertes Verfahren zur Herstellung von OFW-Bauelementen bereitzustellen, mit dem Nachteile der herkömmlichen Verfahren überwunden werden und das insbesondere zur Herstellung von OFW-Bauelementen für höchste Frequenzen bis in den GHz-Bereich geeignet ist, mit herkömmlichen Strukturierungsverfahren, insbesondere lithographischen Strukturierungsverfahren, kompatibel ist, die Ausbildung kleinster Abstände zwischen planar gebildeten metallischen Strukturen ermöglicht und ein Ätzen oder anderweitig strukturelles Verändern der Substratoberfläche vermeidet. Die Aufgabe der Erfindung ist es auch, verbesserte OFW-Bauelemente bereitzustellen, die ein mit hoher Genauigkeit und Reproduzierbarkeit einstellbares, hohes Metallisierungsverhältnis besitzen und die gezielte Anordnung planarer Schichtstrukturen zur Realisierung einer Vielzahl von Funktionen ermöglichen, wie sie an sich von herkömmlichen OFW-Bauelementen bekannt sind.

Diese Aufgaben werden mit einem Verfahren und einem OFW-Bauelement mit den Merkmalen gemäß den Patentansprüchen 1 oder 8 gelöst. Vorteilhafte Ausführungsformen und Anwendungen der Erfindung ergeben sich aus den abhängigen Ansprüchen.

Die Grundidee der Erfindung ist es, zur Herstellung eines OFW-Bauelements auf einem Substrat in einer ersten Abscheidungsphase lateral beabstandete erste elektrisch leitfähige Schichten zu erzeugen, die anschließend allseitig mit mindestens einer Trennschicht einer organischen Substanz belegt werden, wobei die Oberfläche des Substrats in den Abständen zwischen den ersten elektrisch leitfähigen Schichten frei bleibt, und in einer zweiten Abscheidungsphase in den Abständen zwischen den ersten elektrisch leitfähigen Schichten zweite elektrisch leitfähige Schichten zu erzeugen, die von den ersten elektrisch leitfähigen Schichten durch mindestes eine Trennschicht getrennt sind. Die erfindungsgemäße Aufbringung der organischen Trennschicht zwischen den Abscheidungsphasen besitzt den Vorteil, dass die im Ergebnis lateral benachbarten ersten und zweiten elektrisch leitfähigen Schichten durch eine elektrisch isolierende, organische Substanz physikalisch getrennt sind, wobei die Dicke der Trennschicht die Strukturierungsabstände der elektrisch leitfähigen Schichten definiert. Im Unterschied zu herkömmlichen lithographischen Verfahren können damit vorteilhafterweise laterale Schichtabstände im Sub-µm bis nm-Bereich eingestellt werden.

Die Trennschicht besteht allgemein aus organischen Molekülen mit funktionalen Gruppen, die spezifisch an elektrisch leitfähigen Materialien, insbesondere Metallen, Legierungen oder Halbleitern, binden können, mit den jeweiligen Substratmaterialien oder ggf. vorhandenen Substrat-Zwischenschichten jedoch keine Verbindung eingehen. Dies besitzt den Vorteil, dass die Belegung der ersten elektrisch leitfähigen Schichten mit der Trennschicht einfach durch einen Kontakt zwischen den ersten elektrisch leitfähigen Schichten und einer Lösung der organischen Substanz (z. B. durch Eintauchen) erzielt werden kann. Bereits die Ausbildung einer geschlossenen Monolage einer organischen Substanz mit einer Dicke im nm-Bereich genügt zur Trennung der ersten und zweiten elektrisch leitfähigen Schichten. Es werden vorzugsweise organische Moleküle verwendet, die selbstorganisierend Schichten bilden, in denen sich die Moleküle unter Wirkung zwischenmolekularer Kräfte oder chemischer Bindungskräfte, in Form einer geschlossenen Schicht anordnen. Allgemein sind die Trennschichten aus einer Substanz gebildet, die aus einer oder mehreren der folgenden Stoffgruppen zusammengesetzt ist, z. B. Mercaptane, Thiole, Amine, Imine, Phosphine, Alkene, Alkohole, Trichlorsilane, Carbonsäuren, Cyanide oder Proteine.

Die Verwendung von organischen Molekülen, die selbstorganisierend Schichten bilden, besitzt den Vorteil, dass der Abstand zwischen den elektrisch leitfähigen Schichten unabhängig von der Auflösung des angewendeten Strukturierungsverfahrens frei einstellbar ist. Gegebenenfalls besteht die Trennschicht aus mehreren aufeinander folgend aufgebrachten Teilschichten, deren Gesamtdicke den gewünschten lateralen Abstand zwischen benachbarten Kanten von elektrisch leitfähigen Schichten entspricht.

Mit dem erfindungsgemäßen Verfahren lassen sich OFW-Bauelemente für die verschiedensten Anwendungen herstellen. Hierzu zählen insbesondere Komponenten für die Hochfrequenzsignalverarbeitung und Kommunikationstechnik, wie z. B. Hochfrequenzfilter, Kompressionsfilter für die Radartechnik, Verzögerungsleitungen und dergleichen, Schallwandler, Sensoren, optoelektronische Komponenten, wie z. B. Gitter zur akustooptischen Modulation, und Messsysteme für die Grundlagenforschung, wie z. B. Systeme für die Untersuchung von Quanteneffekten. Die Form und Funktion der elektrisch leitfähigen Schichten wird entsprechend der jeweiligen Anwendung gewählt. Die elektrisch leitfähigen Schichten bilden bspw. Metallstreifen oder -finger mit konstanter oder variabler Breite. Sie dienen bspw. als Elektrodenschichten, Antennenschichten und/oder Schallwandler.

Mit besonderem Vorteil wird die Erfindung zur Herstellung von OFW-Bauelementen für die Hochfrequenztechnik verwendet. Das erfindungsgemäße Verfahren ermöglicht die Einstellung eines hohen Metallisierungsgrades (Verhältnis der mit elektrisch leitfähigen Materialien bedeckten Fläche zur Gesamtfläche des Substrates) von η > 0.5, vorzugsweise η > 0.8, mit einer hohen Genauigkeit, Reproduzierbarkeit und Funktionssicherheit. Durch den hohen Metallisierungsgrad der Oberfläche werden mechanische Streuungen minimiert. Die dann noch praktisch wirksamen Anteile der elektrischen Streuungen können einfacher genutzt bzw. korrigiert werden. Es ergibt sich ein homogeneres Betriebsverhalten der OFW-Bauelemente, das sich insbesondere durch eine geringere Temperaturabhängigkeit der Betriebsparameter als bei herkömmlichen Bauelementen auswirkt. Schließlich ist mit dem hohen Metallisierungsgrad eine elektrische Überkopplung zwischen Bauelementen besser abschirmbar.

Insbesondere zur Herstellung von OFW-Bauelementen für die Hochfrequenztechnik erfolgt beim erfindungsgemäßen Verfahren nach Abscheidung der zweiten elektrisch leitfähigen Schichten eine Ablösung der organischen Trennschicht. Nach der Ablösung bilden die Abstände zwischen benachbarten elektrisch leitfähigen Schichten Lücken, in denen das Substrat oder ggf. eine vorhandene Substratzwischenschicht frei liegt. Die Herauslösung der Trennschichten ist für die Erzielung hoher Leistungsparameter von Vorteil. Aus der OFW-Technik ist an sich bekannt, dass organische Polymere Oberflächenwellen dämpfen. Die Erfinder haben festgestellt, dass mit dem erfindungsgemäßen Verfahren die Trennschichten rückstandsfrei entfernt werden können, so dass überraschenderweise keine Dämpfungseffekte durch die erfindungsgemäße Trennschichttechnik entstehen.

Gegenstand der Erfindung ist auch ein OFW-Bauelement, das sich durch ein Substrat mit mehreren, auf der Substratoberfläche oder einer ggf. vorgesehenen Substratzwischenschicht lateral angeordneten elektrisch leitfähigen Schichten auszeichnet, wobei zwischen den elektrisch leitfähigen Schichten Abstände mit einer Breite von weniger als 200 nm, vorzugsweise weniger als 100 nm, gebildet sind. Erfindungsgemäße OFW-Bauelemente zeichnen sich vorteilhafterweise durch einen hohen Metallisierungsgrad aus.

Die Erfindung besitzt die folgenden besonderen Vorteile. Das erfindungsgemäße Verfahren ist kompatibel mit herkömmlichen Herstellungstechnologien, insbesondere mit der Photolithographie. Es können OFW-Bauelemente für wesentlich höhere Frequenzen bis in den GHz-Bereich (z. B. 5 GHz oder darüber) praktikabel und in einer für die Massenproduktion geeigneten Weise hergestellt werden, wie es mit herkömmlichen Lithographieverfahren nicht möglich war. Erfindungsgemäße OFW-Bauelemente sind für den Oberwellenbetrieb geeignet. Sie zeichnen sich durch minimale mechanische Reflektionen aus. Das erfindungsgemäße Verfahren besitzt eine hohe Variabilität. Beispielsweise können OFW-Wandler mit Elektroden unterschiedlicher Höhe hergestellt werden. Außerdem können vergleichweise breite Elektroden mit sehr geringen lateralen Abständen gebildet werden. Damit wird das bei kleinen Leiterquerschnitten auftretende Problem eines erhöhten elektrischen Widerstandes umgangen.

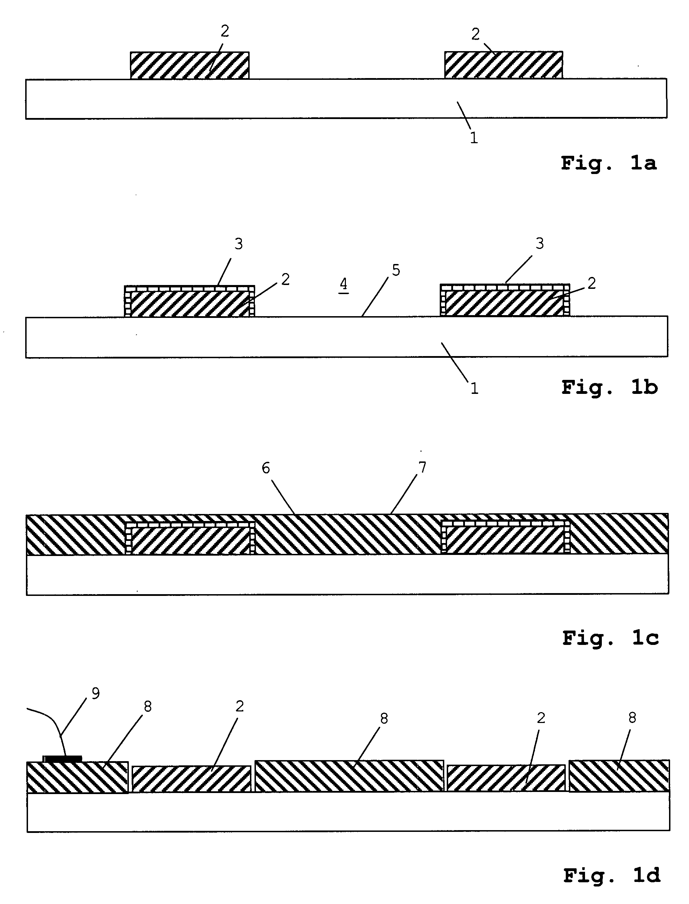

Weitere Vorteile und Einzelheiten der Erfindung werden aus der folgenden Beschreibung der beigefügten Zeichnungen ersichtlich. Die Figuren 1a bis 1d illustrieren schematisch die Abfolge von Prozessschritten gemäß einer Ausführungsform des erfindungsgemäßen Verfahrens.

In Figur 1a ist der erste Schritt des erfindungsgemäßen Verfahrens illustriert. In der ersten Abscheidungsphase werden auf einem Substrat 1 erste elektrisch leitfähige Schichten 2 gebildet. Das Substrat 1 besteht aus einem piezoelektrischen Material, wie z. B. Quarz oder Lithiumniobat. Die geometrischen Parameter des Substrates 1 werden anwendungsabhängig gewählt. Bei einem OFW-Bauelement für die Hochfrequenztechnik besitzt das Substrat 1 bspw. eine Dicke von rd. 0,5 mm und einen Durchmesser von einigen Zoll. Die ersten elektrisch leitfähigen Schichten 2 werden durch ein an sich bekanntes Strukturierungsverfahren, wie z. B. die Photolithographie oder die Elektronenstrahllithographie, hergestellt.

Die ersten elektrisch leitfähigen Schichten 2 bilden bei OFW-Bauelementen für die Hochfrequenztechnik Elektroden, Schallwandler und/oder Streuelemente. Sie bestehen aus Metallen, Halbleitern oder Legierungen. Die leitfähigen Schichten können auch jeweils als Mehrschichtstrukturen gebildet sein. Die geometrischen Parameter der ersten leitfähigen Schichten 2 werden wiederum entsprechend der jeweiligen Anwendung des OFW-Bauelements gewählt. Für die Hochfrequenztechnik werden bspw. streifenförmige Schichten 2 mit einer Dicke im Bereich von z. B. 40 bis 400 nm und einer vom Frequenzstandard abhängigen Breite von z. B. einigen 100 nm bis einigen 10 µm erzeugt. Die konkrete Dimensionierung der Schichten ist an sich aus der OFW-Technologie bekannt. Die ersten metallischen Schichten 2 bestehen bspw. aus Gold.

Nach der ersten Abscheidungsphase zur Erzeugung der ersten leitfähigen Schichten 2 erfolgt gemäß Figur 1b die Belegung der ersten leitfähigen Schichten 2 mit Trennschichten 3 aus einer organischen Substanz. Es werden bspw. Trennschichten 3 aus Mercaptansäure-Molekülen gebildet, die selbstorganisierende Schichten auf den Schichten 2 bilden. Die Moleküle gehen mit den Oberflächen der leitfähigen Schichten 2 eine Reaktion ein, so dass die Schichten 2 vollständig und allseitig umschlossen werden. Dies gilt sowohl für die relativ zur Substratoberfläche senkrechten Seitenkanten der Schichten 2 als auch für die parallel zum Substrat 1 verlaufenden Oberflächen der Schichten 2. Die Moleküle der Trennschicht gehen mit dem Material des Substrats oder einer ggf. vorgesehenen Zwischenschicht (siehe unten) keine Reaktion ein, so dass im Bereich des Abstandes 4 zwischen den ersten leitfähigen Schichten 2 die Oberfläche 5 des Substrates frei und unbeschichtet bleibt.

Die Aufbringung der ersten Trennschichten 3 erfolgt bspw. durch Eintauchen des Substrats 1 mit den Schichten 2 in eine Mercaptansäurelösung. Die Lösung ist zusammengesetzt, wie es an sich von der Herstellung von Beschichtungslösungen für die Bildung selbstorganisierender Schichten bekannt ist (vgl. z. B. S. D. Evans et al., siehe oben). Die Dicke der Trennschichten, die ggf. aus mehreren Teilschichten besteht, liegt vorzugsweise im Bereich von 1 nm bis 100 nm.

Nach der molekularen Beschichtung verbleiben freie Flächen 5 (Figur 1b), die beim nächsten Prozessschritt mit dem Material der zweiten elektrisch leitfähigen Schichten aufgefüllt werden (Deckschicht 6 in Figur 1c). Je nach den gewünschten Dickenverhältnissen der beim fertigen Bauelement (Figur 1d) gewünschten ersten und zweiten leitfähigen Schichten 2, 8 ist die Deckschicht 6 mit einer derartigen Dicke gebildet, dass wie dargestellt eine geschlossene Oberfläche 7 entsteht. Alternativ kann die Deckschicht 6 auch eine geringere Dicke besitzen, die insbesondere kleiner als die Dicke der ersten leitfähigen Schichten 2 ist.

Überraschenderweise hat sich gezeigt, dass die Aufbringung der Deckschicht 6 gemäß Figur 1c durch ein herkömmliches Abscheidungsverfahren die Trennschichten 3 nicht beeinflusst. Es erfolgt weder eine Durchbrechung der Trennschichten 3, noch deren etwaige Polymerisierung in einen unlöslichen Zustand oder dergleichen.

Der in Figur 1d illustrierte Prozessschritt ist vorzugsweise bei der Herstellung von OFW-Bauelementen für die Hochfrequenztechnik vorgesehen. Es erfolgt eine Ablösung der Trennschicht 3, so dass die Oberseiten der ersten leitfähigen Schichten 2 und die benachbarten Lücken freigelegt werden. Dabei werden ggf. auch Teile der über den ersten leitfähigen Schichten 2 verlaufenden Deckschicht 6 (Figur 1c) abgelöst, so dass die zweiten leitfähigen Schichten 8 in den Abständen zwischen den ersten leitfähigen Schichten 2 gebildet sind. Die Ablösung erfolgt beispielsweise durch Auflösung der Trennschichten 3 in Alkohol. Hierzu werden nach dem in Figur 1c dargestellten Schritt ggf. Öffnungsfenster in der Oberfläche 7 gebildet, damit die Trennschicht 3 dem Lösungsmittel ausgesetzt werden kann. Alternativ zu der in Figur 1d illustrierten Ablösung der Trennschichten 3 können diese als elektrische Isolationen auch im Schichtverband bleiben.

Abschließend sind Reinigungs- und weitere Bearbeitungsschritte, wie z. B. Ätzen, Anbringung von Anschlussleitungen (z. B. bei 9) oder die Einbettung in ein Gehäuse (nicht dargestellt) vorgesehen.

Die in Figur 1d illustrierten Stufen durch verschieden dicke erste und zweite leitfähige Schichten 2, 8 sind optional vorgesehen. Die Ausbildung dieser Stufen sind kein notwendiges Merkmal der Erfindung. Sie sind vorzugsweise bei Hochfrequenzanwendungen zur Einstellung bestimmter mechanischer Streuparameter gebildet. Allgemein können benachbarte leitfähige Schichten gleiche oder verschiedene Dicken besitzen.

Es wird betont, dass in den Figuren 1a bis 1d lediglich schematische Illustrationen gezeigt sind. Die leitfähigen Schichten 2, 8 repräsentieren allgemein Elektroden- oder Wandlerschichten oder dgl. Im Falle eines Interdigitalwandlers sind zwei ineinandergreifenden Kämme aus Metallfingern vorgesehen, die gemäß dem erfindungsgemäßen Verfahren strukturiert sind. Auf dem Substrat befinden sich mindestens drei Finger.

Gemäß einer besonderen Ausführungsform der Erfindung kann auf der Oberfläche des Substrats 1 eine Zwischenschicht (nicht dargestellt) vorgesehen sein. Die Zwischenschicht dient als Passivierungsschicht. Sie ist für die Funktionsweise des OFW-Bauelements nicht notwendig und dient dazu, die Selektivität der Bindung der organischen Moleküle der Trennschichten an die ersten leitfähigen Schichten zu verstärken und die Bindung an das Substrat zu verhindern. Beispielsweise wird auf einem Lithiumniobat-Substrat vor der ersten Abscheidungsphase eine SiOₓ-Schicht (z. B. SiO₂) mit einer Dicke von z. B. 2 nm bis 5 nm gebildet. Dies besitzt den Vorteil, dass die Mercaptansäure-Moleküle auf der SiOₓ-Schicht nicht anhaften.

Die in Figur 1d gezeigten leitfähigen Schichten 2, 8 bilden Elektroden mit einem lateralen Abstand, der durch die Dicke der abgelösten Trennschicht bestimmt ist. Die Lücke kann eine Breite von einem nm (Monolage) bis einige 100 nm besitzen, je nach dem welche Moleküle für die Bildung der Trennschicht 3 verwendet wurden und wie viel Teilschichten (Lagen) zur Bildung der Trennschicht 3 aufgetragen wurden. Es werden Metallisierungsgrade größer als 0.5 bis hin zu extremen Metallisierungsgraden von nahezu 1, z. B. 0.97, erzielt.

Die in der vorstehenden Beschreibung, den Zeichnungen und den Ansprüchen offenbarten Merkmalen der Erfindung können sowohl einzeln als auch in beliebiger Kombination für die Verwirklichung der Erfindung in ihren verschiedenen Ausgestaltungen von Bedeutung sein.

## Patentansprüche

1. Verfahren zur Herstellung eines OFW-Bauelements (10) mit einem Substrat (1), auf dem eine Vielzahl von strukturierten leitfähigen Schichten (2, 8) lateral nebeneinander angeordnet werden,
**gekennzeichnet durch**
- eine erste Abscheidungsphase, bei der mit vorbestimmten lateralen Abständen (4) erste leitfähige Schichten (2) erzeugt werden,
- eine allseitige Belegung der ersten leitfähigen Schichten (2) mit Trennschichten (3) aus einer organischen Substanz, wobei die Oberfläche (5) des Substrats (1) in den Abständen (4) frei bleibt, und
- eine zweite Abscheidungsphase, bei der auf dem Substrat (1) zwischen den ersten leitfähigen Schichten (2) zweite leitfähige Schichten (8) erzeugt werden, die von den ersten leitfähigen Schichten (2) **durch** die Trennschichten (3) getrennt sind.

2. Verfahren gemäß Anspruch 1, bei dem die Trennschichten aus Molekülen gebildet sind, die aus den Gruppen der Mercaptane, Thiole, Amine, Imine, Phosphine, Alkene, Alkohole, Trichlorsilane, Carbonsäuren, Cyanide und/oder Proteine ausgewählt sind.

3. Verfahren gemäß Anspruch 1 oder 2, bei dem die Belegung der ersten leitfähigen Schichten (2) mit den Trennschichten (3) durch Eintauchen der ersten leitfähigen Schichten (2) in eine Lösung von Molekülen erfolgt, die selbstorganisierend Schichten auf den ersten leitfähigen Schichten (2) bilden.

4. Verfahren gemäß einem der vorhergehenden Ansprüche, bei dem die Trennschichten (3) mehrere Teilschichten umfassen, die aufeinanderfolgend gebildet sind.

5. Verfahren gemäß einem der vorhergehenden Ansprüche, bei dem die Trennschichten (3) mit einer Dicke im Bereich von 1 nm bis 200 nm, vorzugsweise 10 nm bis 100 nm, gebildet sind.

6. Verfahren gemäß einem der vorhergehenden Ansprüche, bei dem nach der zweiten Abscheidungsphase eine Ablösung der Trennschichten (3) erfolgt, so dass lateral zwischen den ersten und zweiten leitfähigen Schichten (2, 8) freie Zwischenräume gebildet werden.

7. Verfahren gemäß einem der vorhergehenden Ansprüche, bei dem die ersten und zweiten letifähigen Schichten (2, 8) jeweils mit verschiedenen Dicken hergestellt werden, so dass das OFW-Bauelement (10) vorbestimmte mechanische Streuparameter besitzt.

8. OFW-Bauelement (10) mit einem Substrat (1) und einer Vielzahl von elektrisch leitfähigen Schichten (2, 8),
**dadurch gekennzeichnet, dass**
die leitfähigen Schichten (2, 8) lateral mit Abständen von weniger als 200 nm beabstandet angeordnet sind.

9. OFW-Bauelement gemäß Anspruch 8, bei dem die leitfähigen Schichten einen Metallisierungsgrad der Oberfläche des Substrats (1) bilden, der größer als 0.5 ist.

10. OFW-Bauelement gemäß einem der Ansprüche 8 oder 9, bei dem die elektrisch leitfähigen Schichten (2, 8) durch Trennschichten (3) aus organischen Materialien voneinander getrennt sind.

11. Verwendung von organischen Molekülen, die auf leitfähigen Materialien selbstorganisierende Schichten bilden, zur Herstellung von Trennschichten bei der Strukturierung von OFW-Bauelementen.
